# EUROPÄISCHE PATENTANMELDUNG

(11) **EP 1 284 310 A1**
(43) Veröffentlichungstag der Anmeldung: **19.02.2003**
(21) Anmeldenummer: 01119452.9
(22) Anmeldetag: 13.08.2001
(51) Int. Cl.: C30B 11/00, C30B 29/52

(54) **Verfahren zur Herstellung eines einkristallinen Bauteils komplexer Formstruktur**

(71) Anmelder: SIEMENS AKTIENGESELLSCHAFT, 80333 München (DE)
(72) Erfinder: Tiemann, Peter, 58452 Witten (DE)

(57) **Zusammenfassung**

Verfahren zur Herstellung eines einkristallinen Bauteils (1) komplexer Formstruktur mit verschiedenen Strukturteilen (2,3) aus einer metallischen Schmelze, wobei sich die metallische Schmelze in einer mit der Formstruktur korrelierenden Negativform befindet und die Negativform durch ein der Kristallisationsgeschwindigkeit der metallischen Schmelze angepaßtes, den Schmelzpunkt einschließendes Temperaturgefälle unter Bildung einer Erstarrungsfront bewegt wird, dadurch gekennzeichnet, daß zu wenigstens einem der Strukturteile (2,3) der Formstruktur ein individuelles Temperaturgefälle erzeugt wird.

Wenn also die Erstarrungsfront durch ein Strukturteil (2,3) hindurchwachsen muß das ungünstig zu der Erstarrungsfront (7) orientiert ist, so kann für diesen Strukturteil (2,3) oder Bereich ein eigenes Temperaturgefälle erzeugt werden. Damit lassen sich einkristalline Bauteile (1) komplexer Formstruktur auf zuverlässiger und wirtschaftlicher Basis herstellen.

## Beschreibung

Die Erfindung betrifft ein Verfahren zur Herstellung eines einkristallinen Bauteils komplexer Formstruktur mit verschiedenen Strukturteilen aus einer metallischen Schmelze, wobei sich die metallische Schmelze in einer mit der Formstruktur korrelierenden Negativform befindet und die Negativform durch ein der Kristallisationsgeschwindigkeit der metallischen Schmelze angepaßtes, den Schmelzpunkt einschließendes Temperaturgefälle unter Bildung einer Erstarrungsfront bewegt wird.

Die Herstellung einkristalliner Bauteile nimmt mehr und mehr an Bedeutung zu, um immer weitere Leistungssteigerungen, insbesondere im Bereich von Turbinen, zu erzielen. Bei Turbinen, wie Triebwerksturbinen von Flugzeugen oder Gasturbinen zur Energiegewinnung in Kraftwerken, sind Turbinenschaufeln einer hohen Belastung ausgesetzt. Im Zuge der Steigerung von Leistung, Wirkungsgrad und Emission von Gasturbinen werden die thermischen und damit die mechanischen Randbedingungen an Turbinenleitschaufeln der ersten Stufe(n) zunehmend extremer. Besondere Belastungen treten beispielsweise durch zunehmende Ausdünnung der Plattformen, durch Arbeitsmediumswechsel und durch verminderte Außenkuehlung wegen Kühlleckagen im Kanalrandbereich der Gasturbine auf. Eine weitere Leistungssteigerung der Materialeigenschaften wird verlangt, da zur Kühlluftverbrauchsreduzierung in der Gasturbine die Anzahl der Schaufeln im Ring zugunsten zu mehr Größe reduziert wird. Um diese Randbedingungen bewältigen zu können, wird ein Materialwechsel bzw. ein Wechsel der Materialstruktur hin zu Einkristallen angestrebt, wie es teilweise im Laufschaufelbereich von Gasturbinen schon erprobt ist. Bauteile die aus Einkristallen gebildet sind besitzen nur solche Korngrenzen, die bei steigenden Temperaturen keine im Vergleich zum Gesamtmaterial wesentlichen Schwachstellen im Material darstellen.

Die Herstellung einkristalliner Bauteile ist bereits seit vielen Jahren bekannt. Dazu wird zunächst Schmelze in eine Gußform gegossen. Die Gußform hat die negative Formstruktur des herzustellenden Bauteils und wird von daher auch als Negativform bezeichnet. Wenn die Schmelze in der Negativform erstarrt, so erhält sie die gewünschte Formstruktur des Bauteils. Die Formstruktur besteht in der Regel aus mehreren Bereichen, sogenannten Strukturteilen. Die Gußform mit der Schmelze befindet sich innerhalb eines Ofens, so daß die Schmelze weiter beheizt wird und flüssig bleibt. Zur Einkristallerzeugung wird die Negativform langsam aus dem Ofen herausgefahren, so daß außerhalb des Ofens der Erstarrungsprozeß beginnt und die Erstarrungsfront dem Temperaturgefälle folgt. Um dem Einkristall die gewünschte Orientierung zu geben, wird zu Beginn eine schneckenhausförmige, mit Schmelze gefüllte Spitze der Gußform von der äußersten Spitze her erstarrt. Die schneckenhausförmige Spitze wird als Selektionshelix bezeichnet. Die Helix dient zur Selektion der Kristallwachstumsrichtung. Der Einkristall bildet somit die beginnende Erstarrungsfront und wächst im gewünschten Fall durch die gesamte Negativform. Die Negativform muß mit einer der Kristallisationsgeschwindigkeit des Metalls angepaßten Geschwindigkeit durch das Temperaturgefälle geführt werden. Wird die Schmelze schneller durch das Temperaturgefälle geführt als die Kristallwachstumsgeschwindigkeit, so kommt es zur Keimbildung und es bilden sich zusätzliche Kristalle, die eine Orientierung anders als der gewünschte Einkristall haben. Geschieht dies, so ist das Bauteil schadhaft und nicht mehr zu verwenden.

Insbesondere ist eine Einkristallerzeugung von Turbinenleitschaufeln mit weit überhängenden Plattformen sehr schwierig. Die Turbinenleitschaufeln bestehen aus mehreren Strukturteilen, welche die Formstruktur des Bauteils ausmachen. Besonders Problematisch ist der Übergang von einer Plattform zu einem Profilteil und umgekehrt. Die Plattform bildet den Leitschaufelbereich, der in der Turbine parallel, bündig auf der inneren radialen Oberfläche des Leitschaufelträgers liegt und die Profile sind zum einen das Schaufelblatt und zum anderen das Verbindungselement zwischen Leitschaufelträger und Leitschaufel. Problematisch ist bei dieser Anordnung, daß die Ebenennormale der Plattform praktisch senkrecht auf der Ebenennormalen des Profils liegt. Die Wachstumsrichtung des Einkristalls wird in der Regel so gewählt, daß sie im wesentlichen entlang der Längsachse des Profils verläuft und parallel zur Ebenennormalen der Plattform. Die Ebenen stehen fast im wesentlichen senkrecht aufeinander und haben ihr Ausdehnung in verschiedene Richtungen. Es ist demnach ein nahezu schlagartiger Wechsel der Erstarrungsfrontfläche von der geringen Fläche des Profils hin zu der wesentlich breiteren Fläche der Plattform zu realisieren. Es muß in diesem Bereich mit einer Erniedrigung der Absenkgeschwindigkeit der Gußform im Ofen aus dem beheizten in den ungeheizten Bereich geantwortet werden, oder eine entsprechende Anzahl von Kornbeibehaltern in Form einer Weiche vom Profil in die Äußeren Plattformbereiche vorgesehen werden. Beide Möglichkeiten sind sehr schwierig in den Auswirkungen vorhersehbar und zudem Schwankungen im Prozeß unterworfen, so daß die Ausbringrate bzw. die Produktivität abnimmt. Bisher wird dieses Problem zu lösen versucht, indem für die Plattform eine optimale Orientierung zum Temperaturgefälle gesucht wird. Durch einseitiges Ankippen der Gußform im Ofen, um die Orientierung der Plattform zum Temperaturgefälle zu optimieren, wird das Problem in eine Richtung verbessert, da die Erstarrungsfront nun entlang einer Rampe in die Plattform auffächert, so daß der Querschnittwechsel abgeschwächt wird. Trotzdem bleibt ein rechtwinkliger Anschluß bestehen. Problematisch ist weiterhin die Zusammenführung des in der Plattform ausgefächerten Einkristalls zurück in ein schmaleres Strukturteil der Leitschaufel, wobei wiederum das Problem des rechtwinkligen Anschlusses auftritt mit spontanem Wechsel der Fläche der Erstarrungsfront.

Solche und ähnliche Problematiken stellen sich vielfach auch für andere Bauteile anderer Formstruktur dar.

Es stellt sich daher die **Aufgabe**, ein Verfahren dahingehend zur Verfügung zu stellen, das es ermöglicht, einkristalline Bauteile komplexer Formstruktur auf zuverlässiger und wirtschaftlicher Basis herzustellen.

Zur **Lösung** dieser Aufgabe wird vorgeschlagen, daß zu wenigstens einem der Strukturteile der Formstruktur ein individuelles Temperaturgefälle erzeugt wird.

Ein weiteres vorteilhaftes Merkmal der Erfindung sieht vor, daß mit einem individuellen Temperaturgefälle eine individuelle Erstarrungsfront gebildet wird. Auf diese Weise wird die Negativform wie gewohnt durch das Temperaturgefälle geführt. Wenn schließlich die Erstarrungsfront durch ein Strukturteil hindurchwachsen muß, das ungünstig zu der Erstarrungsfront orientiert ist, so kann für diesen Strukturteil oder Bereich ein eigenes Temperaturgefälle erzeugt werden. Dieses Temperaturgefälle kann optimal auf die Bedürfnisse des jeweiligen Strukturteils unabhängig vom Haupttemperaturgefälle ausgerichtet werden. Bei dem Beispiel der Turbinenleitschaufel kann zum Beispiel das Magnetfeld und damit das Temperaturgefälle des Induktionsofens so variiert werden, das statt einer ebenen Erstarrungsfront eine geformte Erstarrungsfront gebildet wir. Zum einen wird demnach ein Temperaturgefälle im Bereich des Profils gebildet, das eine ebene Erstarrungsfront senkrecht zur Längsachse des Profils bildet und zum anderen wird ein Temperaturgefälle erzeugt, das ein Abbiegen der Erstarrungsfront in die Plattform bewirkt und die Erstarrungsfront die Plattform der Höhe nach durchwandert und nicht wie bisher der Breite nach. Es ist als weiterer Vorteil dieser Ausgestaltung zu verstehen, daß wenn die Erstarrungsfront zu den Seiten hin abbiegt und in die Kantenbereiche der Plattform wächst, sie auch dort enden kann und nicht wieder zurück zum Profilteil geführt werden muß. Bisher war es immer notwendig, die in die Breite der Plattform aufgefächerte Erstarrungsfront bei Erreichen des Endes der Erstarrungsfront zurück in das Profil zu führen. Dadurch sind die Probleme der schwierigen Querschnittsübergänge und der Mehrkornbildung beseitigt. Auf diese Weise können Strukturteile, vollständig verschieden gekühlt oder erwärmt werden. Es ist grundsätzlich möglich, jedem Strukturteil ein individuelles Temperaturgefälle zuzuordnen, um damit äußerst komplexe Bauteile als Einkristalle herzustellen.

Vorteilhaft ist die Erfindung derart ausgestaltet, daß verschiedene individuelle Temperaturgefälle verschieden schnell fortbewegt werden. Eine derartiges Verfahren ermöglicht, daß bestimmte Strukturteile weniger schnell durch das Temperaturgefälle geführt werden als andere. Zum Beispiel können bei Verwendung mehrerer Heizelemente, die Heizelemente unabhängig voneinander entlang der Negativform bewegt werden. Auf diese Weise wird das Temperaturgefälle in den verschiedenen Strukturelementen verschieden schnell fortbewegt. Im Fall der Herstellung einer Turbinenleitschaufel kann es beispielsweise notwendig sein, die in die Plattform abgebogene Erstarrungsfront etwas langsamer fortschreiten zu lassen, als die gleichzeitig fortschreitende Erstarrungsfront im Profil. Damit wird es möglich eine optimale Einkristallbildung in der Plattform zu gewährleisten und eine maximal mögliche Geschwindigkeit der fortschreitenden Erstarrung im Profil zu erzielen. Es ist kein Kompromiß zwischen einzelnen Bereichen mehr notwendig. Jeder Bereich bzw. Strukturteil erhält sein individuellen Kompromiß zwischen Erstarrungsgeschwindigkeit und Sicherheit bei der Ausbildung des Einkristalls.

Eine weitere vorteilhaft Ausgestaltung der Erfindung sieht vor, daß individuelle Temperaturgefälle verschiedener Strukturteile individuelle Orientierungen zur Kristallwachstumsrichtung haben. Auf diese Weise ist es möglich, die Erstarrungsfront beliebig zur Wachstumsrichtung und zum jeweiligen Strukturteil zu orientieren. In dem Beispiel der Herstellung einer Turbinenleitschaufel wird demnach zwar das Wachstum ausgehend von dem Übergang zum Profil in die Breite wachsen, jedoch ist die Erstarrungsfront nicht senkrecht zur Wachstumsrichtung ausgerichtet. Die Erstarrungsfront hat also einen Neigungswinkel kleiner 90° zu der Wachstumsrichtung.

Von besonderem Vorteil ist die Erfindung dadurch, daß die verschiedenen Kristallwachstumsrichtungen der verschiedenen Strukturteile im wesentlichen einer Hauptkristallwachstumsrichtung folgen. Unter der Hauptkristallwachstumsrichtung ist diejenige Richtung zu verstehen, der das Kristallwachstum im wesentlichen folgt. Im bisherigen Stand der Technik findet das gesamte Kristallwachstum in einer Richtung statt, nämlich entgegengesetzt zu der Richtung mit der die Negativform aus dem Ofen geführt wird. Mit der Erfindung ist es möglich viele verschiedene Wachstumsrichtungen durch Schaffung verschiedener in verschiedenen Temperaturgefälle zu erzielen. Es wäre zum Beispiel möglich ein sternförmiges, einkristallines Bauteil vom Zentrum aus sternförmig nach außen hin wachsen zu lassen. Für jede Zinke des Bauteils könnte ein individuelles Temperaturgefälle erzeugt werden, das sich zu den Spitzen der Zinken bewegt. Für ein solches Bauteil ist keine Hauptkristallwachstumsrichtung festlegbar. Der Vorteil einer Hauptkristallwachstumsrichtung liegt in der hohen Sicherheit, daß keine Mehrkornbildung stattfindet, die mit groß werdendem Unterschied der Kristallwachstumsrichtungen im Übergang von einem Strukturteil zum anderen ab einem bestimmten Winkel wieder steigt. Daher wird erfindungsgemäß vorgeschlagen, daß die verschiedenen Kristallwachstumsrichtungen nicht mehr als 20° von der Hauptkristallwachstumsrichtung abweichen. Der hier angegebene Winkel ist jedoch nicht beschränkend zu sehen. Mit einer ausreichend feinfühligen Führung des Prozesses sind auch größere Winkel realisierbar.

Es wird in vorteilhafter Weise erfindungsgemäß vorgeschlagen, daß das individuelle Temperaturgefälle von einem unabhängig ansteuerbaren Heizelement gebildet wird. Das Temperaturgefälle für die Hauptkristallwachstumsrichtung kann am einfachsten mit einem entsprechend leistungsstarken Heizelement erzeugt werden, wohingegen die individuellen Temperaturgefälle der verschiedenen Strukturteile mit kleineren Heizelementen erzeugt werden können. Unter ansteuerbaren Heizelementen, sind sowohl Heizelemente die örtlich verfahrbar sind und/oder Heizelemente die in Ihrer Wärmeabgabe regelbar sind zu verstehen. Besonders vorteilhaft ist, daß eine Induktionsspule und/oder ein Strahler als Heizelement eingesetzt wird. So kann je nach Bedürfnis eine entsprechende Wärmequelle gewählt werden.

Eine weitere vorteilhafte Ausgestaltung der Erfindung sieht vor, daß das Temperaturgefälle durch einen Isolationskörper beeinflußt wird. Es ist somit nicht nur möglich das Temperaturgefälle durch Heizkörper zu beeinflussen, sondern auch durch Isolationskörper. Unter Zuhilfenahme von Isolationskörpern lassen sich noch stärkere Temperaturgefälle erzeugen, als unter alleiniger Verwendung von Heizelementen.

Besonders vorteilhaft ist das Verfahren derart, daß mit ihm eine Turbinenleitschaufel hergestellt wird.

Weitere Vorteile und Merkmale der Erfindung werden aus der Beschreibung der Figuren deutlich. Es zeigt:
- Fig. 1: eine schematische Darstellung eines Schnitts durch eine Turbinenleitschaufel mit eingezeichnetem Erstarrungsfrontverlauf bei herkömmlicher Verfahrensweise,
- Fig. 2: eine schematische Darstellung eines Schnitts durch eine Turbinenleitschaufel mit eingezeichnetem Erstarrungsfrontverlauf der erfindungsgemäßen Verfahrensweise.

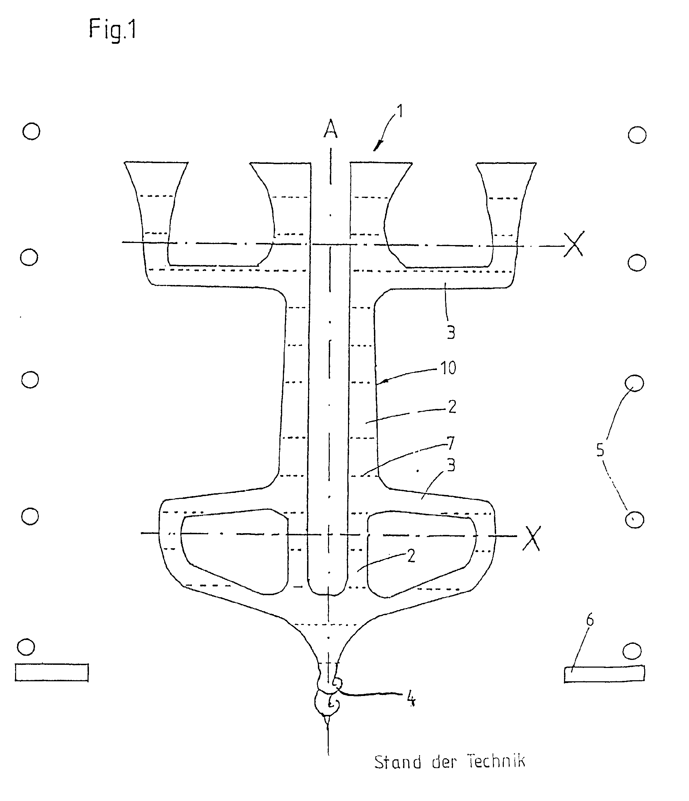

Fig. 1 zeigt ein einkristallines Gußteil 1 aus dem mittels Durchtrennung entlang der Schnittlinien X zwei Turbinenleitschaufeln 10 erhalten werden können. Die Schnittlinie A bezeichnet die Längsachse des Gußteils 1, die parallel zu der Längsachse der anliegenden Profile 2 liegt. Im wesentlichen senkrecht zu den Strukturbereichen die als Profile bezeichnet werden liegen die als Plattformen 3 bezeichneten Strukturbereiche. Da die Fig. 1 einen Schnitt durch die Turbinenleitschaufel zeigt, erstrecken sich die Ebenen senkrecht zur Papierebene. Die Selektionshelix 4 dient zur Herausbildung eines Einkristalls, der anschließend durch das gesamte Bauteil 1 hindurchwachsen soll, damit einkristalline Turbinenleitschaufeln 10 erhalten werden. Die Turbinenleitschaufel 10 ist vor seiner Erstarrung als flüssige Schmelze in der Gußform enthalten. Die Gußform befindet sich zu diesem Zeitpunkt in einem Induktionsofen 5, dessen Spule 5 lediglich angedeutet ist. Der Induktionsofen 5 hält die Schmelze im flüssigen Zustand. Die Gußform wird zur Bildung des Einkristalls mit einer Geschwindigkeit, die an die Kristallwachstumsgeschwindigkeit des Metalls angepaßt ist, nach unten hin aus dem Induktionsofen 5 geführt. Zunächst wird, nachdem die Selektionshelix 4 unter Erstarrungstemperatur gesunken ist, ein einzelner Kristall ausgebildet, der mit weiter sinkender Gußform durch die Gußform hindurchwächst. Zur Erzeugung eines starken Temperaturgefälles ist es üblich unterhalb des Induktionsofens 5 Blenden 6 anzubringen. Da die Induktion hauptsächlich innerhalb der Spule 5 wirkt und das magnetische Feld außerhalb sehr schnell an Stärke verliert, erfolgt die Erstarrung weitestgehend in einer Ebene senkrecht zur Bewegungsrichtung der Gußform. Die Erstarrungsfront 7 ist für verschiedene Zeitabstände gestrichelt in der Fig. 1 angedeutet. Bei fortschreitender Erstarrungsfront 7 kommt es in den nahezu rechtwinkligen Übergängen zwischen den Profilstrukturteilen 2 und den Plattformstrukturteilen 3 zu abrupten Querschnittsänderungen. Hier besteht die hohe Gefahr der Mehrkornbildung, die wiederum zu einer Unbrauchbarkeit des Turbinenleitschaufel 1 führt.

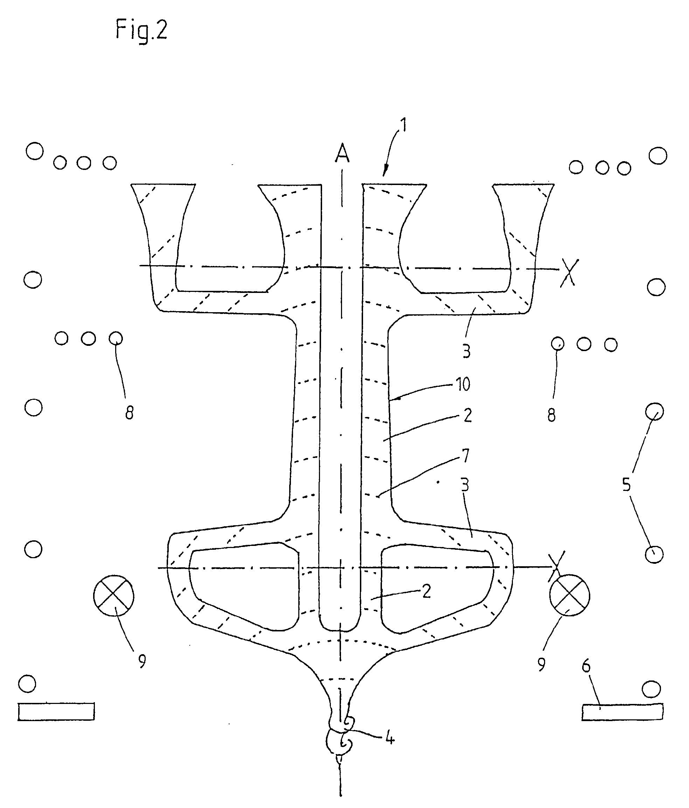

Der Fig. 2 ist das selbe Bauteil 1 zu entnehmen, wie auch der Fig. 1. Der Unterschied liegt jedoch in den zusätzlich zu dem bereits oben genannten Induktionsofen 5 eingesetzten Induktionsspulen 8 und Strahler 9. Sie sorgen dafür, daß das Temperaturgefälle nicht eben sondern erfindungsgemäß geformt ist. Auf diese Weise wird zu den verschiedenen Strukturteilen 2,3 der Formstruktur des Bauteils 1 ein individuelles Temperaturgefälle erzeugt. In diesem Beispiel ist das Temperaturgefälle näherungsweise halbkreisförmig und soll nur schematisch eine Möglichkeit der Formgebung des Temperaturgefälles darstellen. Das bedeutet, daß in den Strukturteilen, die sich nahe der Längsachse A befinden mit einer praktisch in die parallele Richtung verlaufenden Erstarrungsfront durchwachsen werden. Dieser Bereich unterscheidet sich also in seiner Erstarrung nicht wesentlich zu dem Kristallwachstum, wie er in der Fig. 1 gezeigt wird. Die Strukturteile bzw. Bereiche weiter entfernt von der Längsachse A, werden mit einer Erstarrungsfront 7 durchwachsen, die eine Wachstumsrichtung aufweist, die von der Hauptkristallwachstumsrichtung und von der Längsachse A abgeneigt ist. Diese individuelle, verschiedene Kristallwachstumsrichtung sollte vorzugsweise nicht weiter als 20° von der Hauptkristallwachstumsrichtung abweichen. Die Hauptkristallwachstumsrichtung ist bei diesem Gußteil entlang der Längsachse A, da dies die wesentliche Kristallwachstumsrichtung ist. Die individuellen Temperaturgefälle in den Plattformen 3 werden durch die Induktionsspulen 8 und die Strahler 9 erzeugt. Durch die erhöhte Temperatur, die diese Heizelemente 8,9 ausschließlich auf die weiter von der Längsachse A entfernten Bereiche erzeugen, verläuft die Erstarrungsfront 7 von innen nach außen, so daß die Erstarrungsfront 7 die Plattform nicht in der Breite durchläuft, sonder tendenziell in der Höhe. Unter Höhe ist die Ausdehnung parallel zur Längsachse A zu verstehen. Unter der Breite ist die Ausdehnung senkrecht zur Längsachse A zu verstehen. Die gesonderten Heizelemente 8,9 können individuell angesteuert werden. Sie können beispielsweise in der Wärmeerzeugung regelbar sein und/oder in ihrer Position verfahrbar sein. Es ist selbstverständlich, daß es ebenfalls möglich ist, für mehrere Strukturteile mit nur einem einzigen Heizelement individuelle Temperaturgefälle zu erzeugen.

## Patentansprüche

1. Verfahren zur Herstellung eines einkristallinen Bauteils komplexer Formstruktur mit verschiedenen Strukturteilen aus einer metallischen Schmelze, wobei sich die metallische Schmelze in einer mit der Formstruktur korrelierenden Negativform befindet und die Negativform durch ein der Kristallisationsgeschwindigkeit der metallischen Schmelze angepaßtes, den Schmelzpunkt einschließendes Temperaturgefälle unter Bildung einer Erstarrungsfront bewegt wird,
**dadurch gekennzeichnet,**
**daß** zu wenigstens einem der Strukturteile der Formstruktur ein individuelles Temperaturgefälle erzeugt wird.

2. Verfahren nach Anspruch 1, **dadurch gekennzeichnet, daß** mit einem individuellen Temperaturgefälle eine individuelle Erstarrungsfront gebildet wird.

3. Verfahren nach Anspruch 1 oder 2, **dadurch gekennzeichnet, daß** verschiedene individuelle Temperaturgefälle verschieden schnell fortbewegt werden.

4. Verfahren nach einem der Ansprüche 1 bis 3, **dadurch gekennzeichnet, daß** individuelle Temperaturgefälle verschiedener Strukturteile individuelle Orientierungen zur Kristallwachstumsrichtung haben.

5. Verfahren nach einem der Ansprüche 1 bis 4, **dadurch gekennzeichnet, daß** die verschiedenen Kristallwachstumsrichtungen der verschiedenen Strukturteile im wesentlichen einer Hauptkristallwachstumsrichtung folgen.

6. Verfahren nach einem der Ansprüche 1 bis 5, **dadurch gekennzeichnet, daß** die verschiedenen Kristallwachstumsrichtungen nicht mehr als 20° von der Hauptkristallwachstumsrichtung abweichen.

7. Verfahren nach einem der Ansprüche 1 bis 6, **dadurch gekennzeichnet, daß** das individuelle Temperaturgefälle von einem unabhängig ansteuerbaren Heizelement gebildet wird.

8. Verfahren nach einem der Ansprüche 1 bis 7, **dadurch gekennzeichnet, daß** eine Induktionsspule und/oder ein Strahler als Heizelement eingesetzt wird.

9. Verfahren nach einem der Ansprüche 1 bis 8, **dadurch gekennzeichnet, daß** das Temperaturgefälle durch einen Isolationskörper beeinflußt wird.

10. Verfahren nach einem der Ansprüche 1 bis 9, **dadurch gekennzeichnet, daß** mit ihm eine Turbinenleitschaufel hergestellt wird.
